(19) Europäisches Patentamt
European Patent Office
Office européen des brevets

(11) **EP 2 774 246 B1**

(12) **FASCICULE DE BREVET EUROPEEN**

(45) Date de publication et mention
de la délivrance du brevet:
**11.04.2018 Bulletin 2018/15**

(21) Numéro de dépôt: **12773063.8**

(22) Date de dépôt: **20.09.2012**

(51) Int Cl.:
*H02J 7/00* (2006.01)  *H01M 10/44* (2006.01)
*G01R 31/36* (2006.01)  *B60L 11/18* (2006.01)
*H01M 10/42* (2006.01)

(86) Numéro de dépôt international:
**PCT/FR2012/052093**

(87) Numéro de publication internationale:
**WO 2013/064759 (10.05.2013 Gazette 2013/19)**

(54) **PROCEDE ET SYSTEME DE GESTION DE CHARGES ELECTRIQUES DE CELLULES DE BATTERIE**

VERFAHREN UND SYSTEM ZUR VERWALTUNG DER ELEKTRISCHEN LADUNGEN IN BATTERIEZELLEN

METHOD AND SYSTEM FOR MANAGING THE ELECTRIC CHARGES OF BATTERY CELLS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **31.10.2011 FR 1159881**

(43) Date de publication de la demande:
**10.09.2014 Bulletin 2014/37**

(73) Titulaire: **Renault S.A.S.**
**92100 Boulogne-Billancourt (FR)**

(72) Inventeur: **LUCEA, Marc**
**F-78000 Versailles (FR)**

(56) Documents cités:
**JP-A- 2008 271 708     US-A1- 2006 097 698
US-A1- 2009 278 488**

- **CHENG M-W ET AL: "Intelligent Control Battery
Equalization for Series Connected Lithium-Ion
Battery Strings", IEEE TRANSACTIONS ON
INDUSTRIAL ELECTRONICS, IEEE SERVICE
CENTER, PISCATAWAY, NJ, USA, vol. 52, no. 5,
octobre 2005 (2005-10), pages 1297-1307,
XP011139886, ISSN: 0278-0046, DOI:
10.1109/TIE.2005.855673**

**Description**

**Domaine technique de l'invention**

L'invention concerne un procédé de gestion des charges électriques de cellules d'une batterie de stockage d'électricité connectées électriquement en série et/ou en parallèle, ainsi qu'un système de gestion comprenant un circuit électronique d'équilibrage piloté de sorte à mettre en oeuvre un tel procédé.

**État de la technique**

La technologie de batterie Li-ion (Lithium-ion), largement utilisée dans différents secteurs de l'industrie et notamment dans l'automobile, nécessite l'utilisation de circuits d'équilibrage pour garantir l'utilisation à long terme de la batterie. Ces circuits d'équilibrage font généralement partie du système de gestion de la batterie.

En effet, chaque cellule Li-ion (dont l'assemblage en série et en parallèle permet de construire la batterie) doit impérativement rester dans une plage de tension restreinte, au risque d'en dégrader de façon irréversible les performances. Or, lorsqu'un grand nombre de cellules sont assemblées au sein d'une batterie (typiquement 96 bi-cellules au sein des batteries actuellement en cours de développement pour les véhicules électriques), il est inévitable que celles-ci présentent des caractéristiques différentes, et ce d'autant plus que la batterie vieillit : on observera donc parmi toutes les cellules des variations non identiques de certaines caractéristiques qui impactent directement leur état de charge (courant d'autodécharge, rendement faradique, charge maximale,....). Dans les phases de charge ou de décharge de la batterie, comme le courant principal qui parcourt la batterie est le même au niveau de chaque cellule (avec les architectures usuelles des batteries utilisées dans l'automobile), il n'est pas possible de charger ou décharger individuellement une ou plusieurs cellules sans faire appel à des moyens supplémentaires.

D'autres types de cellules électrochimiques (au plomb, par exemple) ne présentent pas les mêmes contraintes que celles à base de Lithium, en termes de plage de tension accessible. En charge, des réactions parasites, qui ne dégradent pas les performances de la cellule, permettent de dissiper l'énergie excédentaire une fois que son état de charge maximal est atteint. Inversement, les décharges très profondes (jusqu'à ce que la charge contenue dans la cellule soit quasiment nulle) sont également possibles. Pour ces types de cellules électrochimiques, la façon la plus simple pour équilibrer la batterie, c'est-à-dire ramener toutes les cellules individuelles au même état de charge, consiste alors à poursuivre la charge jusqu'à ce que toutes les cellules soient entièrement chargées.

Mais cette stratégie n'est pas possible avec tous les types de cellules, notamment les cellules Li-ion: dès lors qu'une seule cellule a atteint son seuil haut de tension (typiquement 4,2V), il est impératif d'interrompre la charge au risque de dégrader la cellule (voire de provoquer un incendie). Des circuits électroniques dédiés sont utilisés, appelés circuits d'équilibrage, qui permettent:

- soit de dissiper l'énergie dans les premières cellules chargées, afin de pouvoir ensuite continuer la charge de la batterie complète : il s'agit d'équilibrage dissipatif,
- soit de transférer l'énergie des cellules les plus chargées vers d'autres cellules : il s'agit alors d'équilibrage non dissipatif.

Les circuits d'équilibrage non dissipatifs présentent plusieurs avantages comparés aux systèmes dissipatifs :

- la chaleur rayonnée est plus faible, sachant que les températures élevées sont dommageables à la fois pour les cellules Li-ion et pour les circuits électroniques,
- la possibilité d'utiliser ces circuits en cours d'utilisation de la batterie, notamment durant la décharge, pour optimiser la répartition des charges individuelles de chaque cellule, l'objectif étant idéalement d'arriver à l'état de charge minimal de chaque cellule simultanément. Ceci permet alors une meilleure utilisation de la batterie, dans la mesure où l'ensemble des charges contenues dans les cellules individuelles est exploité : la limite de la première cellule atteignant son seuil minimal d'état de charge est retardée.

Pour pouvoir exploiter au mieux les possibilités offertes par ces circuits d'équilibrage, notamment non dissipatifs, il est nécessaire de concevoir des stratégies adaptées pour éviter des transferts de charge inutiles voire défavorables, à la fois dans les situations de charge et de décharge.

Les stratégies d'équilibrage connues sont basées soit sur les états de charge (State of Charge, noté « SoC ») individuels de chaque cellule, soit sur la mesure directe de la tension individuelle de chaque cellule. Or l'utilisation de ces critères ne permet pas toujours d'utiliser au mieux l'énergie contenue dans la batterie. Ces stratégies sont en effet adaptées aux circuits d'équilibrage dissipatifs (largement répandus depuis de nombreuses années), mais ne prennent pas en compte toutes les possibilités offertes par les circuits non dissipatifs (qui ne sont actuellement que très peu répandus). Généralement, le seul objectif est d'équilibrer les états de charge des cellules en fin de charge. La dissipation d'énergie durant la décharge ne permet par contre jamais d'accroitre le taux d'utilisation de la batterie :

- si le circuit d'équilibrage utilisé est de type dissipatif, la charge totale utilisée durant la décharge correspond à celle contenue dans la cellule ayant la plus faible charge maximale. L'énergie excédentaire contenue dans les autres cellules est dissipée durant la décharge, et n'est donc pas exploitée utilement,
- si le circuit d'équilibrage est de type non dissipatif, la charge totale utilisée durant la décharge correspond à celle contenue dans la cellule ayant la plus faible charge maximale, plus une partie de l'excédent de charge contenu dans les autres cellules. Cet excédent n'est donc pas entièrement dissipé pour arriver à l'état final, mais partiellement utilisé. Les documents US6215281, US5631534, US7245108 décrivent des solutions d'équilibrage de ce type, s'appuyant uniquement sur les états de charge des cellules, sans distinguer les cas de la charge et de la décharge, ce qui n'est pas optimal.

Le document US2010194339 divulgue une solution d'équilibrage utilisant un paramètre supplémentaire, i.e. prévoyant une vérification du niveau de capacité maximale de charge des cellules. Le document US2006/097698A1 divulgue une méthode et un système pour l'équilibrage des cellules d'une batterie prenant en compte l'état de charge des cellules individuelles. La forme en deux partie de la revendication 1 est basée sur ce document. Le document US2009278488A1 divulgue une méthode pour équilibrer la décharge de partitions de cellules connectées en série.

Toutes ces solutions ne permettent pas une gestion optimale d'une batterie, notamment en cas de dispersions de certaines caractéristiques des cellules. Le mode de fonctionnement de la batterie (charge, repos, ou décharge) n'est pas pris en compte dans la stratégie d'équilibrage.

**Objet de l'invention**

Le but de la présente invention est de proposer une solution de gestion des charges électriques de cellules d'une batterie, qui remédie aux inconvénients listés ci-dessus.

Notamment un objet de l'invention est de fournir un procédé de gestion qui évite des transferts d'énergie inutiles ou défavorables en présence de dispersions sur des caractéristiques physiques des cellules.

Un deuxième objet de l'invention est de fournir un procédé de gestion qui ne soit pas uniquement basé sur les états de charge « SoC » des cellules ou sur leurs tensions individuelles, notamment en condition de décharge ou de repos de la batterie.

Un premier aspect de l'invention concerne un procédé de gestion des charges électriques de cellules d'une batterie de stockage d'électricité connectées électriquement en série et/ou en parallèle, caractérisé en ce qu'il qui comporte :

- une étape d'équilibrage des états de charge des cellules, cette étape étant mise en oeuvre uniquement en phase de charge de la batterie,
- une étape d'équilibrage des quantités de charge contenues dans les cellules, cette étape étant mise en oeuvre uniquement en phase de décharge ou de repos de la batterie.

L'étape d'équilibrage des quantités de charges contenues dans les cellules peut utiliser les états de charge.

L'équilibrage réalisé peut être de type non dissipatif, par transfert d'énergie entre les cellules.

Le procédé peut comprendre les étapes de :

- élaboration de critères d'équilibrage reposant sélectivement sur les états de charge des cellules ou sur la quantité de charges contenues dans les cellules,
- génération de requêtes d'activation d'un circuit électronique d'équilibrage des cellules de la batterie, fonctions des critères d'équilibrage élaborés,
- et émission vers le circuit d'équilibrage des requêtes d'activation générées pour assurer un équilibrage de la batterie selon les critères élaborés.

Les requêtes d'activation fonctions des critères d'équilibrage reposant sur la quantité de charges contenues dans les cellules peuvent dépendre des états de charge des cellules.

L'étape d'élaboration peut utiliser le fait que la batterie soit en phase de charge ou non.

Le procédé peut comprendre une étape préalable de détermination de l'état de charge, de l'état de santé de chacune des cellules, et d'un signal booléen représentatif du fait que la batterie soit en phase de charge ou non.

Un deuxième aspect de l'invention concerne un système de gestion des charges électriques de cellules d'une batterie de stockage d'électricité connectées électriquement en série et/ou en parallèle, comprenant un circuit électronique d'équilibrage des charges électriques des cellules qui comprend des moyens matériels et/ou logiciels qui pilotent le circuit d'équilibrage de sorte à mettre en oeuvre un tel procédé de gestion.

Les moyens matériels et/ou logiciels comprennent de préférence une unité de commande assurant :

- élaboration de critères d'équilibrage reposant sélectivement sur les états de charge des cellules ou sur les quantités de charges contenues dans les cellules,
- génération de requêtes d'activation du circuit électronique d'équilibrage des cellules de la batterie, fonctions des critères d'équilibrage élaborés,
- et émission vers le circuit d'équilibrage des requêtes d'activation générées pour assurer un équilibrage de la batterie selon les critères élaborés.

Un troisième aspect de l'invention concerne un support d'enregistrement de données lisible par l'unité de commande, sur lequel est enregistré un programme informatique comprenant des moyens de codes de programme informatique de mise en oeuvre des phases et/ou des étapes d'un tel procédé.

Un quatrième aspect de l'invention concerne un programme informatique comprenant un moyen de codes de programme informatique adapté à la réalisation des phases et/ou des étapes d'un tel procédé, lorsque le programme est exécuté sur l'unité de commande.

### Description des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 est un schéma d'un exemple de deux cellules présentant à la fois des états de charge et des capacités maximales différents,
- la figure 2 est un diagramme schématisant l'architecture d'un système de gestion selon l'invention,
- la figure 3 illustre le principe de la stratégie de gestion selon l'invention,
- la figure 4 est une vue de détail du bloc 2 de la figure 3,
- et la figure 5 illustre la courbe typique, pour une cellule Li-ion, entre la tension à vide et l'état de charge SoC.

### Description de modes préférentiels de l'invention

L'invention concerne le domaine de l'équilibrage de charges électriques des cellules individuelles d'une batterie de stockage d'électricité dans laquelle ces cellules sont montées en série et/ou en parallèle.

Dans la suite, la notion d'équilibrage doit s'entendre comme l'égalisation des états de charge $SoC_i$ ou des quantités de charge $Q_i$ (suivant que l'on est en charge, en décharge, ou au repos) pour toutes les cellules constituant la batterie. Cette égalisation tient compte des différences de caractéristiques physiques potentiellement évolutives dans le temps pour les cellules, dans le but d'utiliser au mieux l'énergie stockée tout en garantissant une durée de vie la plus longue possible de la batterie.

L'invention repose ainsi sur la constatation qui a été faite selon laquelle, en cas de différences de caractéristiques physiques entre les différentes cellules, la simple utilisation de l'état de charge de celles-ci comme critère d'équilibrage durant la charge et la décharge de la batterie n'est pas satisfaisante. Ceci est particulièrement le cas lorsque les cellules présentent des dispersions de capacités maximales (autrement appelées « charges maximales ») entre elles.

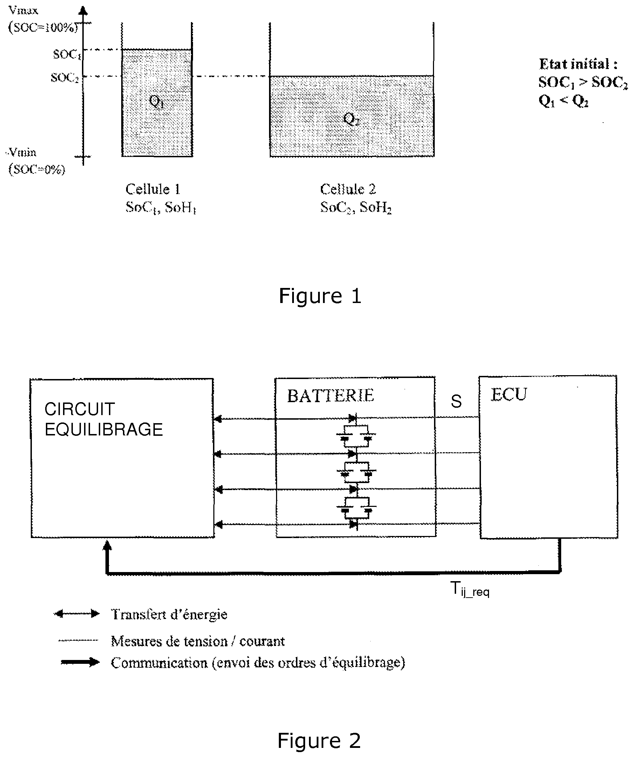

La figure 1 illustre cette dernière problématique. Sur cette figure sont représentées de façon schématique deux cellules individuelles présentant à la fois des états de charge différents et des capacités maximales différentes.

L'état de charge d'une cellule, aussi noté SoC (pour « State of Charge » en terminologie anglo-saxonne) correspond au rapport entre la charge stockée dans cette cellule à un instant donné avec la capacité maximale $Q_{max}$ que cette cellule peut contenir dans sa plage de fonctionnement usuelle à l'instant de la mesure.

Sur la figure 1, l'état de charge correspond au rapport entre la hauteur de remplissage de chaque cellule et sa hauteur maximale. Sa charge correspond à la surface de chaque cellule (la hauteur restant la même, pour respecter les mêmes plages de fonctionnement en tension, la différence de capacité maximale se représente par une différence de largeur). Sur la figure 1 est illustrée une situation où la charge $Q_2$ contenue dans la cellule 2 est supérieure à celle $Q_1$ contenue dans la cellule 1 (la surface grisée représente la charge dans chaque cellule), bien que son SoC soit inférieur. Ainsi :

$$Q_2 = SoC_2 \cdot SoH_2 \cdot Q_{\max\_init_2} > Q_1 = SoC_1 \cdot SoH_1 \cdot Q_{\max\_init_1}$$

Pour une cellule individuelle i, l'état de santé SoHi (« State of Health ») est défini comme le rapport entre la capacité maximale $Q_{\max i}$ que peut contenir la cellule i à un instant donné, et la capacité maximale initiale $Q_{\max\text{-}init\, i}$ que pouvait initialement contenir cette même cellule, par exemple en sortie de ligne de production. Cette capacité initiale est souvent une caractéristique connue du fabriquant par exemple.

Dans une telle situation, une stratégie d'équilibrage selon l'art antérieur basée uniquement sur les états de charge SoC tend à transférer de l'énergie de la cellule 1 vers la cellule 2, car $SoC_1{,} > SoC_2$. Au fur et à mesure que la batterie se décharge ensuite, $SoC_1$ diminue plus vite que $SoC_2$, chacune des deux cellules 1 et 2 étant parcourue par le même courant principal $I_c$ (les deux cellules se vident au même rythme, abstraction faite de l'équilibrage). Ainsi :

$$SoC_i(t) = \frac{Q_i(t)}{Q_{\max i}} = \frac{Q_i(t=0) - \int\limits_{t=0}^{t} I_c \cdot dt}{Q_{\max i}}$$

Avec i=1 ou i=2

Il existe un instant $t_{imv}$ à partir duquel $SoC_1$ devient inférieur à $SoC_2$. À partir de cet instant $t_{imv}$ les transferts d'énergie s'opèrent dans le sens opposé, i.e. de la cellule 2 vers la cellule 1.

Cette stratégie connue présente les inconvénients suivants :

- des pertes énergétiques plus importantes : les premiers transferts réalisés (de la cellule 1 vers la cellule 2) sont inutiles, car finalement suivis des transferts inverses (de la cellule 2 vers la cellule 1). Comme ces transferts s'accompagnent nécessairement de pertes énergétiques, une partie de l'énergie disponible est perdue en effectuant cet aller-retour,
- un équilibrage plus difficile : le temps nécessaire pour transférer l'énergie dans un sens puis dans l'autre est perdu. Compte tenu de la puissance limitée des circuits d'équilibrage, il n'est pas toujours possible, une fois $SoC_2$ devenu supérieur à $SoC_1$, de rééquilibrer la batterie : la cellule 1 peut atteindre sa limite basse de tension ou d'état de charge avant que l'excédent de charge présent dans la cellule 2 n'ait pu être transféré.

L'invention, partant de cette constatation, vise à proposer une stratégie de gestion basée sur des critères d'équilibrage différents (non uniquement reposant sur les états de charge) pour garantir que les transferts opérés entre les cellules soient optimaux au sens de l'utilisation des charges électriques stockées dans les cellules. Cette stratégie s'applique à la fois au cas de la charge et à celui de la décharge, mais aussi à la situation de repos de la batterie. Notamment, les critères d'équilibrage peuvent être différents en fonction du fait que la batterie soit en cours de charge, en cours de décharge ou au repos.

Selon une caractéristique essentielle de l'invention, le procédé de gestion des charges électriques des cellules de la batterie comporte :

- une étape d'équilibrage des états de charge ($SOC_i$) des cellules, cette étape étant mise en oeuvre uniquement en phase de charge de la batterie,
- une étape d'équilibrage des quantités de charge ($Q_i$) contenues dans les cellules, cette étape étant mise en oeuvre uniquement en phase de décharge ou de repos de la batterie.

Durant la décharge ou le repos de la batterie, les paramètres électriques à équilibrer sont donc les quantités des charges $Q_i$ des cellules. Cette étape d'équilibrage est basée sur des critères d'équilibrage reposant sur les quantités des charges $Q_i$ contenues dans les cellules pour les équilibrer autant que possible entre elles. Durant cette étape, les états de charge $SoC_i$ des cellules pourront être également pris en compte afin de ne pas piloter l'équilibrage que sur la seule connaissance des quantités de charges $Q_i$. En effet, la seule utilisation des quantités de charges indépendamment des états de charge peut risquer de conduire à un dépassement préjudiciable d'un seuil haut ou bas d'état de charge $SoC_i$ d'une ou plusieurs cellule(s).

Durant la charge de la batterie par contre, les paramètres électriques à équilibrer sont les états de charge $SoC_i$ des cellules. Cette étape d'équilibrage est basée sur des critères d'équilibrage reposant sur les états de charge $SoC_i$ des cellules pour les équilibrer autant que possible entre eux.

Avantageusement mais de manière non limitative, l'équilibrage réalisé est de type non dissipatif, par transfert d'énergie entre les cellules. Il peut toutefois, en fonction du type de circuit électronique d'équilibrage utilisé, s'agir d'un équilibrage de type dissipatif.

En référence à la figure 2, le système de gestion utilisé pour la batterie comprend un circuit électronique d'équilibrage des cellules, par exemple de type non dissipatif, et des moyens matériels et/ou logiciels qui pilotent le circuit d'équilibrage de sorte à mettre en oeuvre le procédé de gestion ci-dessus. Les moyens matériels et/ou logiciels comprennent notamment une unité de commande ou calculateur (ECU pour « Electronic Control Unit ») capable d'élaborer des critères d'équilibrage $\varepsilon_i$, d'émettre des requêtes d'activation $T_{ij\_req}$ pour les transferts d'énergie à réaliser par le circuit d'équilibrage d'une cellule vers une autre cellule, et par ailleurs de recevoir différents signaux S provenant de la batterie, tels que les tensions individuelles des cellules et/ou des mesures de courant, qui sont utilisés pour estimer certaines grandeurs utilisées par la construction des critères d'équilibrage $\varepsilon_i$.

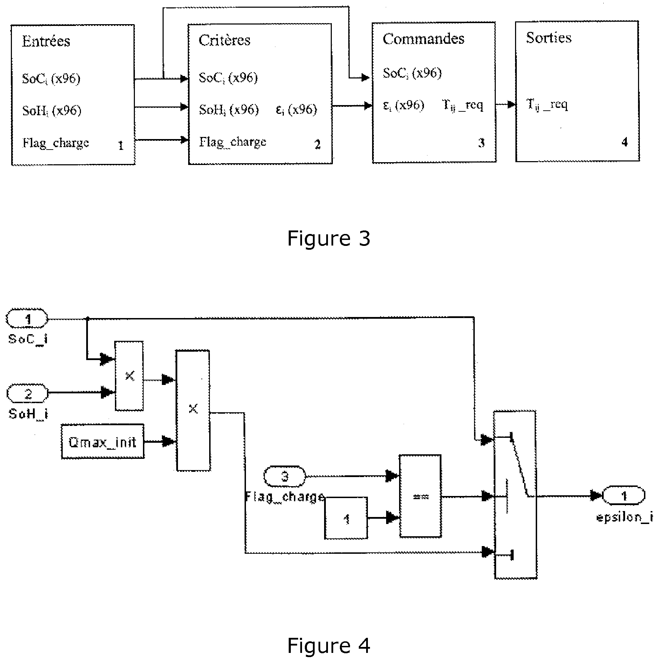

La figure 3 illustre plus en détail le principe général de la stratégie mise en oeuvre par l'unité de commande :

Dans un premier temps, les états de charge $SoC_i$, les états de santé $SoH_i$ pour toutes les cellules d'indice i du pack batterie et un signal booléen « Flag_charge » représentatif du fait que la batterie soit en charge ou non, sont déterminés préalablement à toute autre étape puis sont rassemblés dans le bloc 1 de la figure 3.

Pour une cellule individuelle i, l'état de charge individuel $SoC_i$ (« State of Charge ») peut par exemple être estimé à partir des mesures de tension et de courant réalisées sur la cellule i.

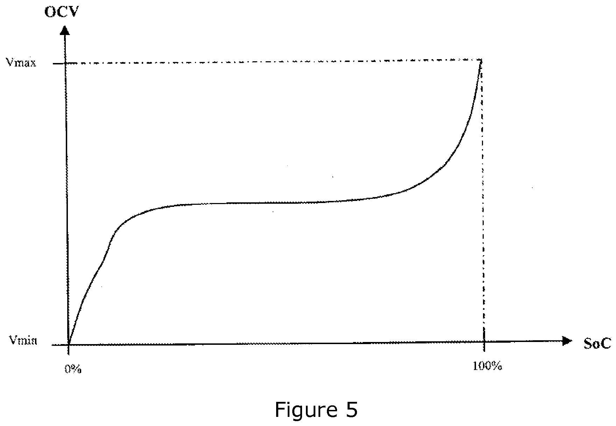

Il convient de préciser que les cellules généralement utilisées dans les batteries haute tension, c'est-à-dire notamment des cellules de type Lithium-ion (Li-ion), respectent une loi liant l'état de charge SoC à la tension en circuit ouvert OCV (pour « Open Circuit Voltage » en terminologie anglo-saxonne) aux bornes de cette cellule (voir figure 5). Cette relation est en première approximation indépendante de la capacité maximale que peut contenir la cellule : si cette capacité maximale diminue (du fait du vieillissement de la cellule, par exemple), la tension maximale sera atteinte pour une charge contenue plus faible.

De plus, le signal booléen « Flag_charge » indique si le véhicule est en charge ou non. Ce signal est généralement envoyé à l'unité de commande par un autre calculateur. Par exemple, le signal vaut 1 si le véhicule est en phase de recharge, et 0 sinon.

Il peut être remarqué que l'unité de commande ECU peut être intégrée de manière générale dans le système global de gestion de la batterie (BMS pour « Battey Management System » en terminologie anglo-saxonne).

Puis dans un deuxième temps, dans le bloc 2 de la figure 3, des critères d'équilibrage $\varepsilon_i$ sont élaborés, reposant sélectivement sur les états de charge $SoC_i$ des cellules ou sur la quantité de charges $Q_i$ stockées dans les cellules. Ce sont les critères d'équilibrage sur lesquels l'algorithme d'équilibrage s'appuiera ensuite. Le bloc 2 qui est illustré en détail sur la figure 4 réalise une étape d'élaboration et d'application de critère qui dépend du fait que la batterie soit en charge ou non :

Si « Flag_charge » vaut 1 (situation où la batterie est en charge), les critères $\varepsilon_i$ les plus adaptés à l'équilibrage de la batterie sont les états de charge $SoC_i$ individuels de chacune des cellules i. L'objectif de l'équilibrage est alors de charger au maximum chacune des cellules i pour emmagasiner le maximum d'énergie possible. Le bloc 2 de la figure 3 fournit donc en sortie les $SoC_i$, pour l'ensemble des N cellules de la batterie. Ainsi :

$$\forall i \in \|1, N\|, \quad \varepsilon_i = SoC_i$$

Par contre si « Flag_charge » vaut 0 (situation où la batterie n'est pas en charge) les critères $\varepsilon_i$ les plus adaptés à l'équilibrage de la batterie sont les charges $Q_i$ contenues dans chacune des cellules i. La charge individuelle $Q_i$ de chaque cellule i est obtenue à partir de son $SoC_i$ et de son $SoH_i$, et de la valeur de la capacité maximale initiale. Ainsi :

$$\forall i \in \|1, N\|, \quad \varepsilon_i = SoC_i \cdot SoH_i \cdot Q_{\max\_init_i} \equiv Q_i$$

Puis dans un troisième temps dans le bloc 3 de la figure 3, qui reçoit en entrée les critères $\varepsilon_i$ élaborés par le bloc 2 mais également les états de charge $SoC_i$ provenant directement du bloc 1 en shuntant le bloc 2, des requêtes d'activation $T_{ij\_req}$ sont générées afin de sélectionner la manière d'activer le circuit électronique d'équilibrage des cellules de la batterie. Ces requêtes $T_{ij\_req}$ sont fonctions des critères d'équilibrage élaborés dans le bloc 2 et tiennent compte de la topologie et des limitations du circuit d'équilibrage. Comme le bloc 3 dépend essentiellement des spécificités du circuit d'équilibrage utilisé, il ne sera pas décrit plus en détail. Les requêtes $T_{ij\_req}$ produites en sortie permettent d'assurer l'équilibrage de la batterie par le circuit sur la base des critères $\varepsilon_i$ choisis (soit équilibrage des quantités de charges $Q_i$,

soit équilibrage des états de charge $SoC_i$). Comme indiqué précédemment, les requêtes d'activation fonctions des critères d'équilibrage $\varepsilon_i$ reposant sur les quantités de charges $Q_i$ contenues dans les cellules i peuvent éventuellement tenir compte également des états de charge $SoC_i$ des cellules.

Puis dans un quatrième temps, le bloc 4 de la figure 3 contient les sorties formées par les requêtes $T_{ij\_req}$ produites par le bloc 3. Puis ces sorties ou requêtes sont émises vers le circuit d'équilibrage pour assurer un équilibrage de la batterie selon les critères $\varepsilon_i$ élaborés.

Durant la charge de la batterie, l'objectif est d'emmagasiner le maximum d'énergie. Il ne sera pas cherché à égaliser les quantités de charges $Q_i$ contenues dans les cellules, mais à remplir chacune à son maximum. Le critère pertinent est donc l'état de charge $SoC_i$ individuel, qui tient compte des limitations de la plage de fonctionnement des cellules.

Durant la décharge ou le repos de la batterie, ou une fois qu'elle est partiellement déchargée, l'objectif est par contre d'égaliser autant que possible les quantités de charges $Q_i$ contenues dans les cellules, sachant que durant la décharge toutes ces cellules i seront soumises au même courant $I_c$ principal tiré sur la batterie (si les cellules sont montées en série). Elles se videront donc au même rythme, et subiront des variations de quantités de charge $Q_i$ identiques. La limitation de la plage de fonctionnement des cellules doit toutefois être respectée, ce qui peut imposer certaines contraintes sur la façon d'égaliser les quantités de charges $Q_i$ : il n'est pas possible de dépasser la limite haute de tension d'une cellule i, correspondant à $SoC_i=100\%$, en voulant égaliser les quantités de charges $Q_i$. Les $SoC_i$ individuels des cellules sont donc également envoyés au bloc n°3 de la figure 3 en shuntant le bloc 2, de sorte que les contraintes sur la plage de fonctionnement des cellules puissent toujours être prises en compte durant l'égalisation des critères $\varepsilon_i$ reposant sur les quantités de charge $Q_i$.

La stratégie d'équilibrage décrite ci-avant permet de compenser le surcoût lié à l'implantation d'un circuit non dissipatif, et de garantir une utilisation optimale de l'énergie contenue dans la batterie même en présence de dispersions sur les capacités maximales de charge individuelles des cellules.

Contrairement aux stratégies d'équilibrage connues qui n'utilisent que l'état de charge $SoC_i$ individuel de chaque cellule, la mise en oeuvre de la stratégie de gestion décrite ci-avant permet une utilisation optimale de l'énergie totale contenue dans la batterie, notamment en présence de dispersions sur les capacités maximales de charge des cellules (c'est-à-dire les charges maximales pouvant être contenues dans les cellules).

L'invention permet de tenir compte et de traiter efficacement des différences de caractéristiques physiques entre les cellules de sorte à compenser leurs différences au moins partiellement (en fonction de la limite de puissance du circuit d'équilibrage). La dispersion des charges maximales peut avoir différentes origines : rendements faradiques différents d'une cellule à l'autre, capacités maximales et/ou courants d'autodécharge différents d'une cellule à l'autre.

Le rendement faradique est défini, durant une charge, par le rapport entre les charges stockées par la cellule et celles qui lui ont été fournies. Le courant d'autodécharge correspond à la vitesse à laquelle une cellule se vide sans qu'aucune charge ne soit connectée à ses bornes. Enfin, la capacité maximale représente la charge maximale que peut emmagasiner une cellule.

L'invention porte aussi sur un support d'enregistrement de données lisible par l'unité de commande, sur lequel est enregistré un programme informatique comprenant des moyens de codes de programme informatique de mise en oeuvre des phases et/ou des étapes du procédé d'équilibrage.

Elle porte aussi sur un programme informatique comprenant un moyen de codes de programme informatique adapté à la réalisation des phases et/ou des étapes du procédé d'équilibrage, lorsque le programme est exécuté sur l'unité de commande.

Avantageusement, l'invention pourra trouver application dans le domaine de l'automobile, notamment dans le cadre d'un véhicule automobile à traction électrique, mettant en oeuvre des batteries construites à partir de cellules individuelles de type Lithium-ion (Li-ion). Cette stratégie de gestion peut toutefois s'appliquer à tout type d'équilibrage, de préférence non dissipatif (mais sans que cela ne soit restrictif), utilisés dans des domaines différents de l'automobile, et pour des chimies de cellules différentes de Li-ion.

## Revendications

1. Procédé de gestion des charges électriques de cellules d'une batterie de stockage d'électricité connectées électriquement en série et/ou en parallèle, **caractérisé en ce qu**'il comporte :

   - une étape d'équilibrage des états de charge ($SOC_i$) des cellules, cette étape étant mise en oeuvre uniquement en phase de charge de la batterie,
   - une étape d'équilibrage des quantités de charge ($Q_i$) contenues dans les cellules, cette étape étant mise en oeuvre uniquement en phase de décharge ou de repos de la batterie.

**2.** Procédé de gestion selon la revendication 1, **caractérisé en ce que** l'étape d'équilibrage des quantités de charges ($Q_i$) contenues dans les cellules utilise les états de charge ($SoC_i$).

**3.** Procédé de gestion selon l'une des revendications 1 ou 2, **caractérisé en ce que** l'équilibrage réalisé est de type non dissipatif, par transfert d'énergie entre les cellules.

**4.** Procédé de gestion selon l'une des revendications 1 à 3, **caractérisé en ce qu'**il comprend les étapes de :

- élaboration de critères d'équilibrage ($\varepsilon_i$) reposant sélectivement sur les états de charge ($SoC_i$) des cellules ou sur la quantité de charges ($Q_i$) contenues dans les cellules,
- génération de requêtes d'activation ($T_{ij\_req}$) d'un circuit électronique d'équilibrage des cellules de la batterie, fonctions des critères d'équilibrage ($\varepsilon_i$) élaborés,
- et émission vers le circuit d'équilibrage des requêtes d'activation ($T_{ij\_req}$) générées pour assurer un équilibrage de la batterie selon les critères ($\varepsilon_i$) élaborés.

**5.** Procédé de gestion selon la revendication 4, **caractérisé en ce que** les requêtes d'activation ($T_{ij\_req}$) fonctions des critères d'équilibrage ($\varepsilon_i$) reposant sur la quantité de charges ($Q_i$) contenues dans les cellules dépendent des états de charge ($SoC_i$) des cellules.

**6.** Procédé de gestion selon l'une des revendications 4 et 5, **caractérisé en ce que** l'étape d'élaboration utilise le fait que la batterie soit en phase de charge ou non.

**7.** Procédé de gestion selon l'une des revendications 1 à 6, **caractérisé en ce qu'**il comprend une étape préalable de détermination de l'état de charge ($SoC_i$), de l'état de santé ($SoH_i$) de chacune des cellules, et d'un signal booléen représentatif du fait que la batterie soit en phase de charge ou non.

**8.** Système de gestion des charges électriques de cellules d'une batterie de stockage d'électricité connectées électriquement en série et/ou en parallèle, comprenant un circuit électronique d'équilibrage des charges électriques des cellules **caractérisé en ce qu'**il comprend des moyens matériels et/ou logiciels qui pilotent le circuit d'équilibrage de sorte à mettre en oeuvre un procédé de gestion selon l'une quelconque des revendications 1 à 7.

**9.** Système de gestion selon la revendication 8, **caractérisé en ce que** les moyens matériels et/ou logiciels comprennent une unité de commande assurant :

- élaboration de critères d'équilibrage ($\varepsilon_i$) reposant sélectivement sur les états de charge ($SoC_i$) des cellules ou sur les quantités de charges ($Q_i$) contenues dans les cellules,
- génération de requêtes d'activation ($T_{ij\_req}$) du circuit électronique d'équilibrage des cellules de la batterie, fonctions des critères d'équilibrage ($\varepsilon_i$) élaborés,
- et émission vers le circuit d'équilibrage des requêtes d'activation ($T_{ij\_req}$) générées pour assurer un équilibrage de la batterie selon les critères ($\varepsilon_i$) élaborés.

**10.** Support d'enregistrement de données lisible par une unité de commande, sur lequel est enregistré un programme informatique comprenant des moyens de codes de programme informatique de mise en oeuvre des phases et/ou des étapes d'un procédé selon l'une des revendications 1 à 7.

**11.** Programme informatique comprenant un moyen de codes de programme informatique adapté à la réalisation des phases et/ou des étapes d'un procédé selon l'une des revendications 1 à 7, lorsque le programme est exécuté sur l'unité de commande.

**Patentansprüche**

**1.** Verfahren zur Verwaltung der elektrischen Ladungen in Batteriezellen einer Elektrizitätsspeicherbatterie, die in Reihe und/oder parallel geschaltet elektrisch miteinander verbunden sind, **dadurch gekennzeichnet, dass** es umfasst:

- einen Schritt des Ausgleichs der Ladezustände ($SoC_i$) der Zellen, wobei dieser Schritt lediglich in der Ladephase der Batterie durchgeführt wird,

- einen Schritt des Ausgleichs der Mengen von Ladungen ($Q_i$), die in den Zellen enthalten sind, wobei dieser Schritt lediglich in der Entlade- oder Ruhephase der Batterie durchgeführt wird.

2. Verfahren zur Verwaltung nach Anspruch 1, **dadurch gekennzeichnet, dass** der Schritt des Ausgleichs der Mengen von Ladungen ($Q_i$), die in den Zellen enthalten sind, die Ladezustände ($SoC_i$) heranzieht.

3. Verfahren zur Verwaltung nach einem der Ansprüche 1 oder 2, **dadurch gekennzeichnet, dass** der realisierte Ausgleich durch Energietransfer zwischen den Zellen von verlustfreier Art ist.

4. Verfahren zur Verwaltung nach einem der Ansprüche 1 bis 3, **dadurch gekennzeichnet, dass** es folgende Schritte umfasst:

   - Aufstellung von Ausgleichskriterien ($\varepsilon_i$), die selektiv auf den Ladezuständen ($SoC_i$) der Zellen oder auf der Menge von Ladungen ($Q_i$), die in den Zellen enthalten sind, beruhen,
   - Erzeugung von Aktivierungsanforderungen ($T_{ij\_req}$) für einen elektronischen Schaltkreis zum Ausgleich der Batteriezellen in Abhängigkeit von den aufgestellten Ausgleichskriterien ($\varepsilon_i$),
   - und Senden der erzeugten Aktivierungsanforderungen ($T_{ij\_req}$) an den Ausgleichsschaltkreis, um einen Ausgleich der Batterie nach den aufgestellten Kriterien ($\varepsilon_i$) sicherzustellen.

5. Verfahren zur Verwaltung nach Anspruch 4, **dadurch gekennzeichnet, dass** die Aktivierungsanforderungen ($T_{ij\_req}$) in Abhängigkeit von den Ausgleichskriterien ($\varepsilon_i$), die auf der Menge von Ladungen ($Q_i$), die in den Zellen enthalten sind, beruhen, von den Ladezuständen ($SoC_i$) der Zellen abhängen.

6. Verfahren zur Verwaltung nach einem der Ansprüche 4 und 5, **dadurch gekennzeichnet, dass** der Schritt der Aufstellung den Umstand heranzieht, dass sich die Batterie in der Ladephase befindet oder nicht.

7. Verfahren zur Verwaltung nach einem der Ansprüche 1 bis 6, **dadurch gekennzeichnet, dass** es einen vorherigen Schritt der Bestimmung des Ladezustands ($SoC_i$), des Gesundheitszustands ($SoH_i$) jeder der Zellen und eines Booleschen Signals umfasst, das repräsentativ für den Umstand ist, dass sich die Batterie in der Ladephase befindet oder nicht.

8. System zur Verwaltung der elektrischen Ladungen in Batteriezellen einer Elektrizitätsspeicherbatterie, die in Reihe und/oder parallel geschaltet elektrisch miteinander verbunden sind, umfassend einen elektronischen Schaltkreis zum Ausgleich der elektrischen Ladungen der Zellen, **dadurch gekennzeichnet, dass** er Hardware- und/oder Software-Mittel umfasst, die den Ausgleichsschaltkreis so steuern, dass er ein Verfahren zur Verwaltung nach einem der Ansprüche 1 bis 7 durchführt.

9. System zur Verwaltung nach Anspruch 8, **dadurch gekennzeichnet, dass** die Hardware- und/oder Software-Mittel eine Befehlseinheit umfassen, die Folgendes sicherstellt:

   - Aufstellung von Ausgleichskriterien ($\varepsilon_i$), die selektiv auf den Ladezuständen ($SoC_i$) der Zellen oder auf den Mengen von Ladungen ($Q_i$), die in den Zellen enthalten sind, beruht,
   - Erzeugung von Aktivierungsanforderungen ($T_{ij\_req}$) des elektronischen Schaltkreises zum Ausgleich der Batteriezellen in Abhängigkeit von den aufgestellten Ausgleichskriterien ($\varepsilon_i$),
   - und Senden der erzeugten Aktivierungsanforderungen ($T_{ij\_req}$) an den Ausgleichsschaltkreis, um einen Ausgleich der Batterie nach den aufgestellten Kriterien ($\varepsilon_i$) sicherzustellen.

10. Datenspeichermedium, das durch eine Befehlseinheit lesbar ist und auf dem ein Datenverarbeitungsprogramm gespeichert ist, das Datenverarbeitungsprogrammcode-Mittel zur Durchführung der Phasen und/oder Schritte eines Verfahrens nach einem der Ansprüche 1 bis 7 umfasst.

11. Datenverarbeitungsprogramm, umfassend ein Datenverarbeitungsprogrammcode-Mittel, das für die Realisierung der Phasen und/oder Schritte eines Verfahrens nach einem der Ansprüche 1 bis 7 geeignet ist, wenn das Programm in der Befehlseinheit ausgeführt wird.

**Claims**

1. Method for managing the electric charges of cells of an electricity storage battery, which are electrically connected in series and/or in parallel, **characterized in that** it comprises:

   - a step in which the states of charge ($SoC_i$) of the cells are balanced, this step being performed only during the battery charging phase, and
   - a step in which the quantities of charge ($Q_i$) contained in the cells are balanced, this step being performed only during the battery discharging or rest phase.

2. Management method according to Claim 1, **characterized in that** the step in which the quantities of charge ($Q_i$) contained in the cells are balanced utilizes the states of charge ($SoC_i$).

3. Management method according to either of Claims 1 and 2, **characterized in that** the balancing performed is of the non-dissipative type, by transfer of energy between the cells.

4. Management method according to one of Claims 1 to 3, **characterized in that** it comprises the following steps:

   - establishment of balancing criteria ($\varepsilon_i$) based selectively on the states of charge ($SoC_i$) of the cells or on the quantity of charge ($Q_i$) contained in the cells,
   - generation of activation requests ($T_{ij\_req}$), dependent on the established balancing criteria ($\varepsilon_i$), for activation of an electronic balancing circuit for balancing the cells of the battery,
   - and emission to the balancing circuit of the generated activation requests ($T_{ij\_req}$) so as to ensure a balancing of the battery in accordance with the established criteria ($\varepsilon_i$).

5. Management method according to Claim 4, **characterized in that** the activation requests ($T_{ij\_req}$) dependent on the balancing criteria ($\varepsilon_i$) based on the quantity of charge ($Q_i$) contained in the cells are dependent on the states of charge ($SoC_i$) of the cells.

6. Management method according to either of Claims 4 and 5, **characterized in that** the establishment step utilizes the fact that the battery is or is not in the charging phase.

7. Management method according to one of Claims 1 to 6, **characterized in that** it comprises a prior step of determining the state of charge ($SoC_i$), the state of health ($SoH_i$) of each of the cells, and a Boolean signal representative of the fact that the battery is or is not in the charging phase.

8. System for managing the electric charges of cells of an electricity storage battery, which are electrically connected in series and/or in parallel, comprising an electronic balancing circuit for balancing the electric charges of the cells, **characterized in that** it comprises hardware and/or software means, which control the balancing circuit so as to perform a management method according to any one of Claims 1 to 7.

9. Management system according to Claim 8, **characterized in that** the hardware and/or software means comprise a control unit ensuring:

   - establishment of balancing criteria ($\varepsilon_i$) based selectively on the states of charge ($SoC_i$) of the cells or on the quantities of charge ($Q_i$) contained in the cells,
   - generation of activation requests ($T_{ij\_req}$), dependent on the established balancing criteria ($\varepsilon_i$), for activation of the electronic balancing circuit for balancing the cells of the battery,
   - and emission to the balancing circuit of the generated activation requests ($T_{ij\_req}$) so as to ensure a balancing of the battery in accordance with the established criteria ($\varepsilon_i$).

10. Data recording support, which can be read by a control unit and on which a computer program is recorded comprising computer program code means for performing phases and/or steps of a method according to one of Claims 1 to 7.

11. Computer program comprising a computer program code means suitable for carrying out phases and/or steps of a method according to one of Claims 1 to 7 when the program is run on the control unit.

Figure 1

⟷ Transfert d'énergie

---------- Mesures de tension / courant

⟶ Communication (envoi des ordres d'équilibrage)

Figure 2

Figure 3

Figure 4

Figure 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6215281 B
- US 5631534 A
- US 7245108 B
- US 2010194339 A
- US 2006097698 A1
- US 2009278488 A1